# EUROPÄISCHE PATENTSCHRIFT

(11) **EP 3 912 451 B1**
(45) Veröffentlichungstag und Bekanntmachung des Hinweises auf die Patenterteilung: **27.09.2023**
(21) Anmeldenummer: 21162056.2
(22) Anmeldetag: 11.03.2021
(51) Int. Cl.: A01D 41/127, H03K 17/955, G01F 1/64, G01F 1/74

(54) **SENSORSYSTEM ZUR ERFASSUNG VON ELEMENTEN EINES ERNTEGUTSTROMES**
SENSOR SYSTEM FOR DETECTING ELEMENTS OF A STREAM OF HARVESTED CROPS
SYSTÈME DE CAPTEUR PERMETTANT DE DÉTECTER LES ÉLÉMENTS D'UN FLUX DE PRODUITS RÉCOLTÉS

(30) Priorität: 20.05.2020 DE 102020113658
(43) Veröffentlichungstag der Anmeldung: 24.11.2021
(73) Patentinhaber: CLAAS Selbstfahrende Erntemaschinen GmbH, 33428 Harsewinkel (DE)
(72) Erfinder: Neitemeier, Dennis, 59510 Lippetal (DE); Baumgarten, Joachim, 48361 Beelen (DE); Wilken, Andreas, 49143 Bissendorf (DE); Bormann, Bastian, 33334 Gütersloh (DE); Witte, Johann, 58730 Fröndenberg (DE)
(74) Vertreter: CLAAS Gruppe

(56) Entgegenhaltungen:
- DE-A1- 19 934 881
- DE-A1-102015 213 037
- JP-A- H09 159 500

## Beschreibung

Die Erfindung betrifft ein Sensorsystem zur Erfassung von Elementen eines Erntegutstromes, insbesondere in einer landwirtschaftlichen Arbeitsmaschine.

Aus der EP3222133A1 Verfahren zum Erfassen einer Kornzahl eines Erntegutstromes bekannt. Dabei werden Körner, die auf eine Prallfläche des Sensors aufprallen, mittels eines Messsignals erfasst. Der Sensor ist dabei nicht in der Lage zu erkennen, was für Elemente auf die Prallfläche des Sensors aufprallen.

Aus der EP3301407A1 ist ein Verfahren zur Bestimmung eines Massenstromes bekannt. Dabei wird Kraft gemessen, die ein Massenstrom auf einen Sensor ausübt. Der Sensor ist dabei nicht in der Lage zu erkennen, was für Elemente die Kraft ausüben.

Aus der DE19934881 A1 ist ein Sensorsystem gemäß dem Oberbegriff des Anspruchs 1 bekannt.

Aufgabe der Erfindung ist es einen Sensor bereitzustellen, der mehr Informationen über die erfassten Elemente liefert.

Die Aufgabe wird gelöst durch ein Sensorsystem zur Erfassung von Elementen eines Erntegutstromes, insbesondere in einer landwirtschaftlichen Arbeitsmaschine, wobei das Sensorsystem einen Schwingkreis und eine Messeinrichtung umfasst, wobei der Schwingkreis aus zumindest einem kapazitiven Bauelement mit einer Kapazität und einem induktiven Bauelement mit einer Induktivität besteht, wobei der Schwingkreis eine Resonanzfrequenz aufweist, wobei die Resonanzfrequenz von der Kapazität und der Induktivität abhängt, wobei die Messeinrichtung zur Bestimmung der Resonanzfrequenz des Schwingkreises vorgesehen und eingerichtet ist, wobei das kapazitive Bauelement im Bereich des Erntegutstromes angeordnet ist, wobei das kapazitive Bauelemente dazu eingerichtet ist, dass die Kapazität durch einzelne Elemente des Erntegutstromes beeinflusst wird, wobei das Sensorsystem dazu vorgesehen und eingerichtet ist aus der Resonanzfrequenz des Schwingkreises auf zumindest eine Eigenschaft des jeweiligen Elementes des Erntegutstromes zu schließen, wobei das kapazitive Bauelement als planarer Kondensator ausgebildet ist.

Das Sensorsystem misst die Auswirkung des Elementes des Erntegutstromes auf die Kapazität des kapazitiven Bauelementes. Durch die Änderung der Kapazität wird die Resonanzfrequenz des Schwingkreises verändert. Die Änderung der Resonanzfrequenz bzw. der Kapazität kann gemessen werden und damit das Element des Erntegutstromes erfasst werden. Die erfassten Elemente des Erntegutstromes können gezählt werden.

Das induktive Bauelement kann in die Messeinrichtung integriert sein, bspw. in Form eines integrierten Schaltkreises. Bei bekannter Induktivität kann aus der Resonanzfrequenz direkt auf die Kapazität geschlossen werden. Anstelle der Änderung der Resonanzfrequenz kann daher auch die Änderung der Kapazität bestimmt werden.

Die Stärke der Änderung der Kapazität und der Resonanzfrequenz hängt von der Permittivität des Elementes des Erntegutstromes ab. Mit der Bestimmung der Resonanzfrequenz ist das Sensorsystem in der Lage auf die Permittivität des Elementes zu schließen. Die Permittivität wird auch Permittivitäts- oder Dielektrizitätszahl genannt.

Das Sensorsystem ist bevorzugt dazu vorgesehen und eingerichtet ist zwischen Kornelementen und Nichtkornelementen, insbesondere Strohelementen, zu unterscheiden. Kornelemente besitzen eine wesentlich größere Permittivität als Strohelemente. Ein Kornelement ändert daher die Resonanzfrequenz stärker als ein Strohelement. Die zu unterscheidende Eigenschaft der Elemente des Erntegutstromes ist in diesem Fall ob das jeweilige Element ein Kornelement oder ein Strohelement ist.

Die Messeinrichtung bestimmt die Resonanzfrequenz bevorzugt mit einer vorbestimmten Messfrequenz. Durch die regelmäßige Bestimmung der Resonanzfrequenz wird der zeitliche Verlauf der Messung von Elementen des Erntegutstromes durch das Sensorsystem bestimmt.

Die Resonanzfrequenz ist bevorzugt größer ist als 1kHz. Je höher die Resonanzfrequenz ist, umso schneller kann sie genau vermessen werden.

Die Messfrequenz ist bevorzugt kleiner als ein Zehntel der Resonanzfrequenz. Durch die im Verhältnis zur Resonanzfrequenz kleine Messfrequenz können in jeder Messung mindestens zehn Perioden der Schwingungen des Schwingkreises zur Bestimmung der Resonanzfrequenz vermessen werden. Dadurch wird die Bestimmung der Resonanzfrequenz genauer als wenn nur wenige Perioden vermessen werden.

Die Messfrequenz multipliziert mit der Länge des kapazitiven Bauelementes in Bewegungsrichtung des Erntegutstromes ist bevorzugt größer ist als 2m/s, besonders bevorzugt größer als 30m/s, ganz besonders bevorzugt größer als 40m/s. Die Messfrequenz multipliziert mit der Länge des kapazitiven Bauelementes Bewegungsrichtung des Erntegutstromes gibt die Bewegungsgeschwindigkeit der Elemente des Erntegutstromes an, die noch mit Sicherheit von dem Sensorsystem erfasst werden. Bei einer Bewegungsgeschwindigkeit von 2m/s lassen sich Körner sicher erfassen, die vom Spelz getrennt lediglich von der Erdanziehungskraft beschleunigt werden. Dies ist bspw. in einem Mähdrescher am Schüttler oder am Reinigungssieb der Fall. Bei einer Bewegungsgeschwindigkeit von 10m/s lassen sich Körner sicher erfassen, die im Mähdrescher von der Dreschtrommel oder einem Rotor beschleunigt wurde. Bei einer Bewegungsgeschwindigkeit von 25m/s lassen sich Körner sicher erfassen, die in einem Feldhäcksler zum Auswurf beschleunigt wurden.

Von der Messfrequenz zu unterscheiden ist die Abtastfrequenz. Die Abtastfrequenz gibt an wie oft eine Spannung und/oder ein Strom im Schwingkreis bestimmt wird. Die Abtastfrequenz ist mindestens doppelt so groß wie die vom Schwingkreis erwartete Resonanzfrequenz. Bevorzugt ist die Abtastfrequenz zehnmal so groß wie die vom Schwingkreis erwartete Resonanzfrequenz.

Das kapazitive Bauelement ist erfindungsgemäß als planarer Kondensator ausgebildet. Die Kapazität eines planaren Kondensators wird durch Elemente in der direkten Nähe seiner Oberfläche beeinflusst. Ein planarer Kondensator kann am Rand des Erntegutstromes montiert werden und detektiert die an ihm vorbeifließenden Elemente des Erntegutstromes. Ein planarer Kodensator stört den Erntegutstrom weniger als ein Plattenkondensator mit zwei Platten.

Das kapazitive Bauelement ist bevorzugt als Interdigitalkondensator ausgestaltet. Ein Interdigitalkondensator weißt über seine Oberfläche eine gleichmäßige Sensitivität für Elemente aus dem Erntegutstrom auf. Ein Element beeinflusst die Resonanzfrequenz also in gleichem Maße unabhängig von seiner Position.

Das kapazitive Bauelement kann, gemäß einem Beispiel, das nicht unter den Schutzbereich der Erfindung fällt, auch als Plattenkondensator ausgebildet sein. Bei der Anbringung des Plattenkondensators an einem siebartigen Element werden die Platten des Plattenkondesators bevorzugt an zwei nebeneinanderliegenden Begrenzungen eines Durchlasses des Siebes angebracht. Durch diese Anbringung wird der jeweilige Durchlass nicht verengt.

Das Sensorsystem ist bevorzugt in einem Mähdrescher verbaut. Die Erfindung betrifft in diesem Fall einen Mähdrescher mit einem siebartigen Element und einem Sensorsystem, wobei das Sensorsystem einen Schwingkreis und einer Messeinrichtung umfasst, wobei der Schwingkreis zumindest ein kapazitives Bauelement mit einer Kapazität und ein induktives Bauelement umfasst,
wobei das kapazitive Bauelement in unmittelbarer Nähe des siebartigen Elementes angebracht ist, wobei das siebartige Element durchlaufende Elemente eines Erntegutstromes das kapazitive Bauelement passieren und zumindest temporär die Kapazität des kapazitiven Bauelementes verändern, wobei die Messeinrichtung zur Bestimmung der Resonanzfrequenz des Schwingkreises vorgesehen und eingerichtet ist, wobei das Sensorystem dazu vorgesehen und eingerichtet ist aus der Resonanzfrequenz des Schwingkreises auf zumindest eine Eigenschaft des jeweiligen Elementes des Erntegutstromes zu schließen.

Das Sensorsystem zählt in diesem Fall durch den Mähdrescher fließende Elemente des Erntegutstromes.

Das kapazitive Element ist bevorzugt in Bewegungsrichtung des Erntegutstromes hinter dem siebartigen Element angeordnet. Das Sensorsystem zählt damit nur die durch das siebartige Element hindurchtretenden Elemente des Erntegutstromes. Elemente des Erntegutstromes, die an dem siebartigen Element vorbei fließen werden nicht gezählt.

Das siebartige Element ist bevorzugt ein Dreschkorb, eine Klappenmatrix unter einem Rotor, ein Schüttler oder ein Reinigungssieb. Ein siebartiges Element zeichnet sich durch eine Gitterstruktur aus. Die Größe der Öffnungen ist dabei variabel und kann von Element zu Element variieren und ggf. verstellbar sein. So sind die Öffnungen eines Reinigungssiebes in ihrer Größe verstellbar und werden meist auf eine Größe eingestellt, die kaum größer ist als die Körner, welche geerntet werden sollen. Die Öffnungen eines Dreschkorbes hingegen sind typischerweise von fester Größe und wesentlich größer als die Körner.

Die Oberflächennormale des planaren Kondensators ist bevorzug im Wesentlichen senkrecht zur Bewegungsrichtung des Erntegutstromes ausgerichtet. Die Elemente des Erntegutstromes bewegen sich dadurch im Wesentlichen entlang der Oberfläche des Kondensators. Diese Anordnung kombiniert eine möglichst geringe Störung des Erntegutstromes mit einer guten Zählung der Elemente des Erntegutstromes.

Das kapazitive Bauelement ist bevorzugt auf einer Oberfläche des siebartigen Elementes angebracht. Direkt auf der Oberfläche des siebartigen Elementes aufgebracht ist die Störung des Erntegutstromes minimal.

Die Erfindung wird nachstehend anhand eines Ausführungsbeispiels näher erläutert. Die Figuren zeigen in
- Fig. 1:: einen Mähdrescher mit Hordenschüttler,
- Fig. 2:: einen Mähdrescher mit einem Trennrotor,
- Fig. 3:: einen Rotor eines Axialabscheiders
- Fig. 4:: ein Schema eines Sensorsystems zur Erfassung von Elementes eines Erntegutstromes,
- Fig. 5:: einen Interdigitalkondensator,
- Fig. 6:: eine Siebebene eines Mähdreschers,
- Fig. 7:: ein Detail der Siebebene.

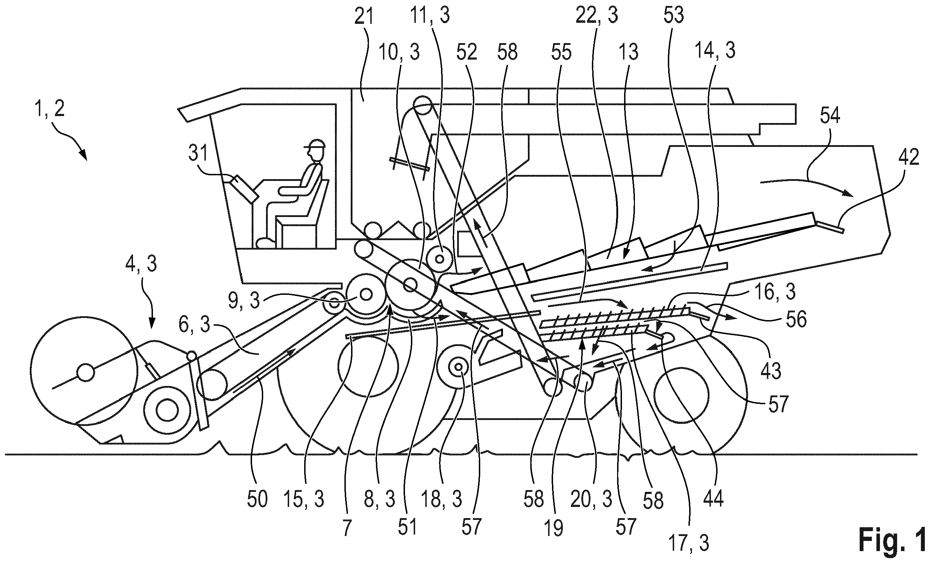

Figur 1 zeigt schematisch eine als Mähdrescher 1 ausgeführte selbstfahrende landwirtschaftliche Arbeitsmaschine 2. Der Mähdrescher 1 weist eine Vielzahl von Arbeitsorganen 3 zur Förderung und/oder Verarbeitung des Erntegutes (nicht dargestellt) auf.

Das Erntegut wird mittels eines Vorsatzgerätes 4 aufgenommen, und in einem zugeführten Erntegutstrom 50 mittels eines Schrägförderers 6 zum Dreschwerk 7 geführt. Das Dreschwerk 7 umfasst einen Dreschkorb 8, eine Beschleunigungstrommel 9, eine Dreschtrommel 10 und eine Umlenktrommel 11. Am Dreschkorb 8 erfolgt eine erste Abscheidung von freibeweglichen Körnern (nicht dargestellt) in Form eines ersten Erntegutstroms 51.

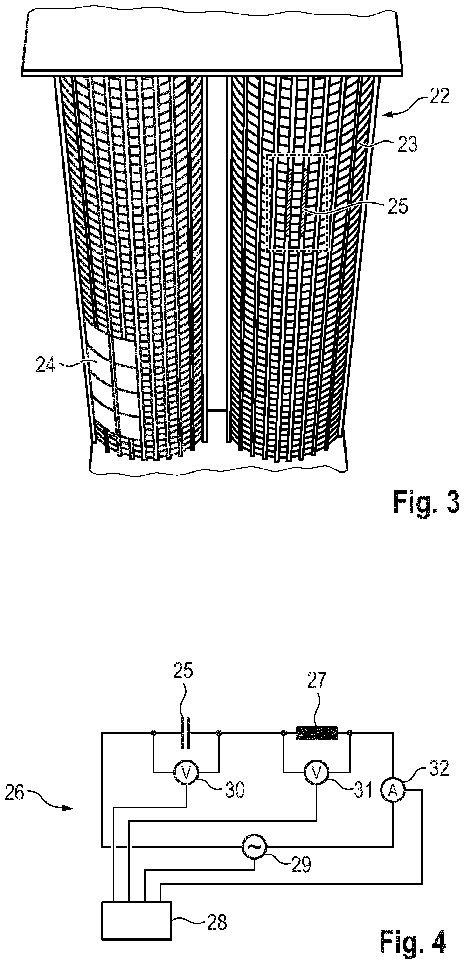

Nach Durchlaufen des Dreschwerks 7 wird ein aus diesem austretender zweiter Erntegutstrom 52, der Halmteile und noch nicht ausgedroschene Körner enthält, einer als Hordenschüttler 12 ausgeführten Trenneinheit 13 zugeführt. Die im zweiten Erntegutstrom 52 noch enthaltenen freibeweglichen Körner werden mittels des Hordenschüttler 12 in Form eines dritten Erntegutstroms 53 auf einen Rücklaufboden 14 und einen Vorbereitungsboden 15 abgeschieden. Der restliche vierte Erntegutstrom 54, vornehmlich bestehend aus Halmteilen, wird aus der Erntemaschine 2 herausgefördert. Der vierte Erntegutstrom 54 überquert dabei einen ersten Verlustkornzähler 42. Der Verlustkornzähler 42 ist ein Sensorsystem 26, wie es in Figur 4 dargestellt ist. Ein Kondensator, bevorzugt ein planarer Interdigitalkondensator, in auf einem flachen Oberfläche angebracht über die der vierte Erntegutstrom hinweg fließt. Das Sensorsystem erfasst die Elemente des Erntegutstromes und unterscheidet dabei zwischen Korn- und Nichtkornelementen.

Die Erfindung bezieht sich nicht nur auf Mähdrescher 1 mit einer als Hordenschüttler 12 ausgebildeten Trenneinheit 13. Sondern es liegt im Rahmen der Erfindung, dass es sich auch um einen Mähdrescher 1 mit Trennrotoren oder anderen Trenneinheiten 13 handeln kann.

Sowohl der aus dem Dreschkorb 8 als auch der aus dem Hordenschüttler 12 austretende, vornehmlich Körner enthaltende erste und dritte Erntegutstrom 51, 53 werden über den Rücklaufboden 14 und den Vorbereitungsboden 15 zu einem fünften Erntegutstrom 55 zusammengeführt und einer aus mehreren Siebebenen 16,17 und einem Gebläse 18 bestehenden Reinigungseinheit 19 zugeführt. Die Körner des fünften Erntegutstroms 55 werden hier gereinigt und Nicht-Kornbestandteile, wie beispielsweise Spreu- und Halmteile, in Form eines sechsten Erntegutstroms 56 abgetrennt und aus der Erntemaschine 2 herausgefördert. Der sechste Erntegutstrom 56 überquert dabei einen zweiten Verlustkornzähler 43. Der Verlustkornzähler 43 ist ein Sensorsystem 26, wie es in Figur 4 dargestellt ist. Die Funktionsweise ist identisch zum ersten Verlustkornzähler 42.

Der dargestellte Mähdrescher 1 weist zudem einen Überkehrschnecke 20 auf, über den ein nicht vollständig ausgedroschener siebter Erntegutstrom 57 dem Dreschwerk 7 erneut zugeführt werden kann. Der siebte Erntegutstrom 57 überquert bei seinem Weg zur Überkehrschnecke 20 einen Überkehr-Kornzähler 44. Der Überkehr-Kornzähler 44 ist ein Sensorsystem 26, wie es in Figur 4 dargestellt ist. Die Funktionsweise ist identisch zum ersten Verlustkornzähler 42.

Ein gereinigter, aus Körnern bestehender achter Erntegutstrom 58 wird einem Korntank 21 zugeführt. Die gezeigten Erntegutströme 50-58 sind nicht abschließend zu verstehen und hängen von der technischen Konfiguration der Erntemaschine 2 ab.

Der dargestellte Mähdrescher 1 weist an den siebartigen Elementen, also dem Dreschkorb 8, dem Schüttler 12 und den Siebebenen 16, 17 eine Vielzahl von Sensorsystemen auf. Die durch die siebartigen Elemente 8, 12, 16, 17 hindurchtretenden Elemente der Erntegutströme werden von den Sensorsystemen gezählt. Dabei unterscheiden die Sensorsysteme zwischen Körnen und Strohelemente.

Durch eine Vielzahl Sensorsystemen kann unterschieden werden an welchem siebartigen Element 8, 12, 16, 17 wie viele Körner abgeschieden werden und wie viel Stroh durch die siebartigen Elemente 8, 12, 16, 17 tritt. Daraus kann geschlossen werden wie effektiv die jeweiligen Arbeitsorgane 9, 10, 11, 12, 16, 17 arbeiten.

An jedem siebartigen Element sind eine Vielzahl an Sensorsystemen über die Fläche verteilt. So kann bspw. erkannt werden wo am Schüttler 12 wie viele Kornelemente und Strohelemente in den dritten Erntegutstrom 53 übergehen. Darauf kann erkannt werden ob der Schüttler gut eingestellt ist und die Einstellung ggf. geändert werden.

Die Zählungen der Sensorsysteme laufen in einer Kontrolleinheit 31 zusammen. Die Kontrolleinheit 31 zeigt die Zählungen dem Bediener an, sodass dieser die Einstellungen der Arbeitsorgane 3 anpassen kann. Alternativ kann die Kontrolleinheit 31 die Einstellungen selbsttätig vornehmen.

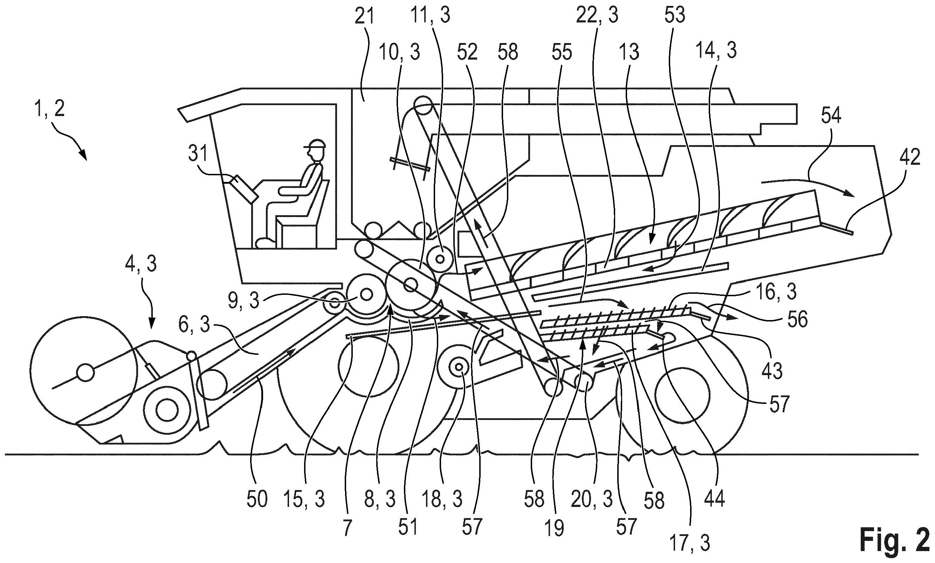

Figur 2 zeigt eine alternative Version eines Mähdreschers 1 mit einem Trennrotor 22. Im Folgenden werden nur die Unterschiede zu Figur 1 erläutert. Der Rotor 22 dient als Alternative zum Hordenschüttler 12 und nimmt den zweiten Erntegutstrom 52 auf. Die Außenseite des Rotors 22 weist eine Gitterstruktur 23 auf und ist damit ein siebartiges Element. Die Elemente des dritten Ertengutstromes 53 verlassen den Trennrotor durch die Gitterstruktur 23. Sensoren an der Gitterstruktur 23 zählen die Elemente des dritten Erntegutstromes 53. Die Sensoren unterscheiden dabei zwischen Kornelementen und Strohelemente.

Figur 3 zeigt einen Trennrotor 22 des Mähdreschers 1 aus Figur 2. Ein Trennrotor 22 ist ein Axialabscheider. In Figur 3 ist der Trennrotor 22 von unten gezeigt. Die Außenseite des Trennrotors 22 weist eine Gitterstruktur 23 auf. Die Öffnungen der Gitterstruktur 23 sind teilweise mit Klappen 24 verschließbar. Direkt an der Gitterstruktur 23 sind planare Kondensatoren 25 angebracht. Die Oberfläche der Kondensatoren 25 erstreckt sich senkrecht zur Außenseite des zylindrischen Trennrotors 22. Die Elemente des Erntegutstromes im Trennrotor 22 verlassen den Trennrotor 22 üblicherweise senkrecht zur Außenseite des Trennrotors 22. Die Oberflächennormale des Kondensators 25 ist damit im Wesentlichen senkrecht zur Bewegungsrichtung des Erntegutstromes ausgerichtet. Die planaren Kondensatoren 25 können auch auf der Oberfläche der Klappen 24 angebracht sein. Wenn die Klapppen 24 geöffnet sind, in die Oberflächennormale des Kondensators 25 im Wesentlichen senkrecht zur Bewegungsrichtung des Erntegutstromes ausgerichtet. Je nach Ausgestaltung des Sensorsystems kann auch das ganze Sensorsystem direkt an der Gitterstruktur 23 oder an den Klappen 24 angebracht werden.

Figur 4 zeigt ein Schema eines Sensorsystems 26 zur Erfassung von Elementes eines Erntegutstromes. Das Sensorsystem 25 umfasst einen Kondensator 25, ein induktives Bauelement 27, wie eine Spule, und eine Messeinrichtung 28. Die Messeinrichtung 28 regt den Schwingkreis aus Kondensator und Spule über eine Spannungsquelle 29 an und misst eine erste Spannung 30 über dem Kondensator 25, eine zweite Spannung 31 über der Spule 27 und/oder den Strom 32 durch den Schwingkreis. Es versteht sich, dass der Schwingkreis sowohl als Reihenschaltung als auch als Parallelschaltung ausgeführt sein kann.

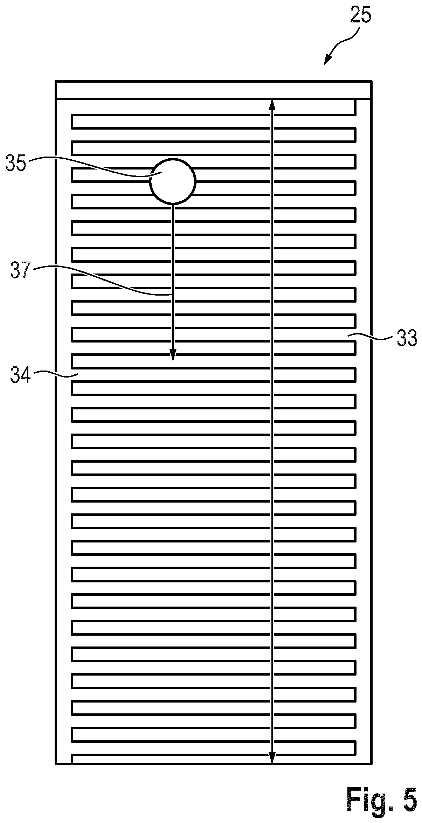

Figur 5 zeigt ein Schema eines Interdigitalkondensators 25. Der Interdigitalkondensator 25 weist zwei Elektroden 33, 34 auf. Die Elektroden 33, 34 weisen jeweils eine Vielzahl an fingerartigen Strukturen auf, wobei die fingerartigen Strukturen in einander verschränkt sind. Ein Element 35 aus dem Erntegutstrom beeinflusst die Kapazität des Interdigitalkondensators 25 unabhängig von seiner Position an der Oberfläche des Interdigitalkondensators 25. Das Element 35 des Erntegutstromes kann daher über die gesamte Länge 36 des Interdigitalkondensators 25 in der Bewegungsrichtung 37 des Erntegutstromes detektiert werden.

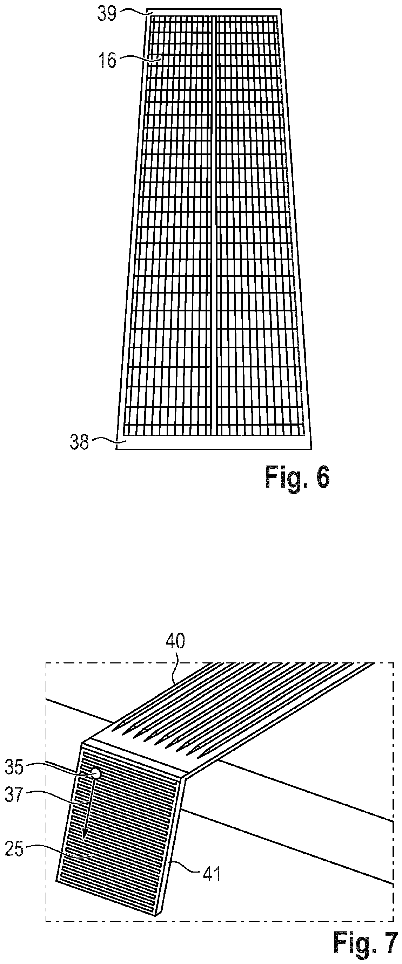

Figur 6 zeigt eine Siebebene 16 des Mähdreschers 1. Der fünfte Erntegutstrom 55 fällt von oben auf das vordere Ende 38 der Siebebene 16. Das Erntegut wird durch zyklische Bewegungen der Siebebene durch Wurfbewegungen an das hintere Ende 39 der Siebebene 16 befördert. Dabei fallen Elemente des Erntegutstromes durch die gitterartige Struktur des Siebelementes.

Figur 7 zeigt ein Detail der Siebebene 16 im Querschnitt. Die Siebebene 16 weist beweglich Elemente auf. Ein oberer Teil 40 des beweglichen Elementes kann von einer in der Ebene der Siebebene 16 in eine Position senkrecht zur Ebene der Siebebene gekippt werden. Je nach Anstellungswinkel des beweglichen Elements sind die Öffnungen der gitterartigen Strukur größer oder kleiner. Durch den Anstellungswinkel kann daher die Größe der Elemente des Erntegutes bestimmt werden, die durch die gitterartige Struktur hindurchtreten können. Ein unterer Teil 41 des beweglichen Elementes ist in einem festen Winkel mit dem oberen Teil des beweglichen Elementes verbunden. An dem unteren Teil 41 des beweglichen Elementes ist ein Kondensator 25 befestigt. Elemente 35 des Erntegutstromes, die durch die Öffnungen treten beeinflussen die Kapazität des Kondensators 25. Die Bewegungsrichtung 37 der Elemente ist dabei im Wesentlichen senkrecht zur Siebebene 16. Der Kondensator 25 ist Teil eines in Figur 4 gezeigten Sensorsystems 26. Die Änderung der Kapazität des Kondensators wird durch das Sensorsystem 26 gemessen. Aus der Größe der Änderung der Kapazität des Kondensators 25 kann auf die Permitivität des jeweiligen Elementes 35 geschlossen werden. Über die Permitivität können bspw. Körner von Strohelementen unterschieden werden.

Es versteht sich, dass jedes Sensorsystem 26 eine Vielzahl an Kondensatoren 25 umfassen kann. Durch kleinere Kondensatoren 25 können die Elemente des jeweiligen Erntegutstromes besser erfasst werden, da weniger Elemente während einer Messung gleichzeitig gemessen werden. Im Idealfall befindet sich bei jeder Zählung nur ein Element im Messbereich. Befinden sich während einer Messung mehrere Elemente im addiert sich der Einfluss der Elemente auf die Kapazität des Kondensators und die Anzahl und Art der Elemente muss entsprechend berechnet werden. Damit möglichst alle Elemente des jeweiligen Erntegutstromes erfasst werden, ist es vorteilhaft bei kleineren Kondensatoroberflächen die Messfrequenz höher zu wählen. Ebenso ist es vorteilhaft die Messfrequenz höher zu wählen, wenn die Bewegungsgeschwindigkeit des Erntegutstromes höher ist. Bei zu kleinen Messfrequenzen können sich Elemente des Erntegutstromes zwischen zwei Messungen über den Kondensator bewegen ohne vom Sensorsystem erfasst zu werden. Dem Hersteller der landwirtschaftlichen Erntemaschine sind die Größen der Kondensatoren und die Bewegungsgeschwindigkeiten der Erntegutströme bekannt, sodass er entsprechende Messfrequenzen vorbestimmen kann.

### Bezugszeichenliste

- 1: Mähdrescher
- 2: Landwirtschaftliche Arbeitsmaschine
- 3: Arbeitsorgan
- 4: Vorsatzgerät
- 50: Zugeführter Erntegutstrom
- 51: Erster Erntegutstrom
- 52: Zweiter Erntegutstrom
- 53: Dritter Erntegutstrom
- 54: Vierter Erntegutstrom
- 55: Fünfter Erntegutstrom
- 56: Sechster Erntegutstrom
- 57: Siebter Erntegutstrom
- 58: Achter Erntegutstrom
- 6: Schrägförderer
- 7: Dreschwerk
- 8: Dreschkorb
- 9: Beschleunigungstrommel
- 10: Dreschtrommel
- 11: Umlenktrommel
- 12: Hordenschüttler
- 13: Trenneinheit
- 14: Rücklaufboden
- 15: Vorbereitungsboden
- 16: Siebebene
- 17: Siebebene
- 18: Gebläse
- 19: Reinigungseinheit
- 20: Überkehrschnecke
- 21: Korntank
- 22: Rotor
- 23: Gitterstruktur
- 24: Klappen
- 25: Kondensator
- 26: Sensorsystem
- 27: Spule
- 28: Messeinrichtung
- 29: Spannungsquelle
- 30: Erste Spannug
- 31: Zweite Spannung
- 32: Strom
- 33: Elektrode
- 34: Elektrode
- 35: Element eines Erntegutstromes
- 36: Länge
- 37: Bewegungsrichtung
- 38: Vorderes Ende der Siebebene
- 39: Hinteres Ende der Siebebene
- 40: Oberer Teil des beweglichen Elementes
- 41: Unter Teil des beweglichen Elementes
- 42: Erster Verlustkornzähler
- 43: Zweiter Verlustkornzähler
- 44: Überkehr-Kornzähler

## Patentansprüche

1. Sensorsystem zum Erfassen von Elementen (35) eines Erntegutstromes (50, 51, 52, 53, 54, 55, 56, 57, 58), insbesondere in einer landwirtschaftlichen Arbeitsmaschine (2),
wobei das Sensorsystem (26) einen Schwingkreis und eine Messeinrichtung (28) umfasst, wobei
der Schwingkreis aus zumindest einem kapazitiven Bauelement (25) mit einer Kapazität und einem induktiven Bauelement (27) mit einer Induktivität besteht,
wobei der Schwingkreis eine Resonanzfrequenz aufweist, wobei die Resonanzfrequenz von der Kapazität und der Induktivität abhängt,
wobei die Messeinrichtung (28) zur Bestimmung der Resonanzfrequenz des Schwingkreises vorgesehen und eingerichtet ist,
wobei das kapazitive Bauelement (25) im Bereich des Erntegutstromes (50, 51, 52, 53, 54, 55, 56, 57, 58) angeordnet ist,
wobei das kapazitive Bauelemente (25) dazu eingerichtet ist, dass die Kapazität durch einzelne Elemente (35) des Erntegutstromes (50, 51, 52, 53, 54, 55, 56, 57, 58) beeinflusst wird,
wobei das Sensorsystem (26) dazu vorgesehen und eingerichtet ist aus der Resonanzfrequenz des Schwingkreises auf zumindest eine Eigenschaft des jeweiligen Elementes (35) des Erntegutstromes (50, 51, 52, 53, 54, 55, 56, 57, 58) zu schließen,
**dadurch gekennzeichnet,**
**dass** das kapazitive Bauelement (25) als planarer Kondensator (25) ausgebildet ist.

2. Sensorsystem nach Anspruch 1, **dadurch gekennzeichnet, dass** das Sensorsystem (26) dazu vorgesehen und eingerichtet ist zwischen Kornelementen und Nichtkornelementen, insbesondere Strohelementen, des Erntegutstromes (50, 51, 52, 53, 54, 55, 56, 57, 58) zu unterscheiden.

3. Sensorsystem nach einem der vorhergehenden Ansprüche, **dadurch gekennzeichnet, dass** die Messeinrichtung (28) die Resonanzfrequenz mit einer vorbestimmten Messfrequenz bestimmt.

4. Sensorsystem nach einem der vorhergehenden Ansprüche, **dadurch gekennzeichnet, dass** die Resonanzfrequenz größer ist als 1kHz.

5. Sensorsystem nach einem der Ansprüche 3 oder 4, **dadurch gekennzeichnet, dass** die Messfrequenz kleiner ist als ein Zehntel der Resonanzfrequenz.

6. Sensorsystem nach einem der Ansprüche 3 bis 5, **dadurch gekennzeichnet, dass** die Messfrequenz multipliziert mit der Länge des kapazitiven Bauelementes (25) in Bewegungsrichtung (27) des Erntegutstromes (50, 51, 52, 53, 54, 55, 56, 57, 58) größer ist als 2m/s, bevorzugt größer als 10m/s, besonders bevorzugt größer als 25m/s.

7. Sensorsystem nach einem der vorhergehenden Ansprüche, **dadurch gekennzeichnet, dass** das kapazitive Bauelement (25) als Interdigitalkondensator (25) ausgestaltet ist.

## Claims

1. A sensor system for detecting elements (35) of a flow of harvested material (50, 51, 52, 53, 54, 55, 56, 57, 58), in particular in an agricultural working machine (2),
wherein the sensor system (26) comprises an oscillating circuit and a measuring device (28), wherein
the oscillating circuit consists of at least one capacitive structural element (25) with a capacitance and an inductive structural element (27) with an inductance, wherein the oscillating circuit has a resonance frequency, wherein the resonance frequency depends on the capacitance and the inductance, wherein the measuring device (28) is provided and configured to determine the resonance frequency of the oscillating circuit,
wherein the capacitive element (25) is disposed in the region of the flow of harvested material (50, 51, 52, 53, 54, 55, 56, 57, 58),
wherein the capacitive element (25) is configured such that the capacitance is influenced by individual elements (35) of the flow of harvested material (50, 51, 52, 53, 54, 55, 56, 57, 58),
wherein the sensor system (26) is provided and configured to infer at least one property of the respective element (35) of the flow of harvested material (50, 51, 52, 53, 54, 55, 56, 57, 58) from the resonance frequency of the oscillating circuit,
**characterized in that**
the capacitive structural element (25) is configured as a flat capacitor (25).

2. The sensor system according to claim 1, **characterized in that** the sensor system (26) is provided and configured to distinguish between grain elements and non-grain elements, in particular straw elements, of the flow of harvested material (50, 51, 52, 53, 54, 55, 56, 57, 58).

3. The sensor system according to one of the preceding claims, **characterized in that** the measuring device (28) determines the resonance frequency with a predetermined frequency of measurement.

4. The sensor system according to one of the preceding claims, **characterized in that** the resonance frequency is greater than 1 kHz.

5. The sensor system according to claim 3 or claim 4, **characterized in that** the frequency of measurement is less than one tenth of the resonance frequency.

6. The sensor system according to one of claims 3 to 5, **characterized in that** the frequency of measurement multiplied by the length of the capacitive structural element (25) in the direction of movement (27) of the flow of harvested material (50, 51, 52, 53, 54, 55, 56, 57, 58) is greater than 2 m/s, preferably greater than 10 m/s, particularly preferably greater than 25 m/s.

7. The sensor system according to one of the preceding claims, **characterized in that** the capacitive structural element (25) is provided as an interdigital capacitor (25).

## Revendications

1. Système de capteur pour détecter des éléments (35) d'un flux de produit récolté (50, 51, 52, 53, 54, 55, 56, 57, 58), en particulier dans une machine de travail agricole (2),
le système de capteur (26) incluant un circuit oscillant et un équipement de mesure (28),
le circuit oscillant étant constitué d'au moins un composant capacitif (25) avec une capacité et d'un composant inductif (27) avec une inductance, le circuit oscillant présentant une fréquence de résonance,
la fréquence de résonance dépendant de la capacité et de l'inductance,
l'équipement de mesure (28) étant prévu et agencé pour déterminer la fréquence de résonance du circuit oscillant,
le composant capacitif (25) étant agencé de façon que la capacité soit influencée par des éléments individuels (35) du flux de produit récolté (50, 51, 52, 53, 54, 55, 56, 57, 58),
le système de capteur (26) étant prévu et agencé pour déduire de la fréquence de résonance du circuit oscillant au moins une propriété de l'élément respectif (35) du flux de produit récolté (50, 51, 52, 53, 54, 55, 56, 57, 58),
**caractérisé en ce que**
le composant capacitif (25) est conformé en condensateur planaire (25).

2. Système de capteur selon la revendication 1, **caractérisé en ce que** le système de capteur (26) est prévu et agencé pour distinguer entre éléments de grain et éléments de non-grain, en particulier éléments de paille, du flux de produit récolté (50, 51, 52, 53, 54, 55, 56, 57, 58) .

3. Système de capteur selon une des revendications précédentes, **caractérisé en ce que** l'équipement de mesure (28) détermine la fréquence de résonance avec une fréquence de mesure prédéterminée.

4. Système de capteur selon une des revendications précédentes, **caractérisé en ce que** la fréquence de résonance est supérieure à 1 kHz.

5. Système de capteur selon une des revendications 3 ou 4, **caractérisé en ce que** la fréquence de mesure est inférieure à un dixième de la fréquence de résonance.

6. Système de capteur selon une des revendications 3 à 5, **caractérisé en ce que** la fréquence de mesure multipliée par la longueur du composant capacitif (25) dans la direction de déplacement (27) du flux de produit récolté (50, 51, 52, 53, 54, 55, 56, 57, 58) est supérieure à 2 m/s, préférentiellement supérieure à 10 m/s, particulièrement préférentiellement supérieure à 25 m/s.

7. Système de capteur selon une des revendications précédentes, **caractérisé en ce que** le composant capacitif (25) est conformé en condensateur interdigital (25).
